# EUROPÄISCHE PATENTSCHRIFT

(11) **EP 1 288 966 B1**
(45) Veröffentlichungstag und Bekanntmachung des Hinweises auf die Patenterteilung: **13.05.2009**
(21) Anmeldenummer: 02017983.4
(22) Anmeldetag: 10.08.2002
(51) Int. Cl.: G11C 19/00, G11C 19/28

(54) **Steuerregister**
Control register
Régistre de contrôle

(30) Priorität: 31.08.2001 DE 10142675
(43) Veröffentlichungstag der Anmeldung: 05.03.2003
(73) Patentinhaber: Infineon Technologies AG, 81669 München (DE)
(72) Erfinder: Kock, Ernst-Josef, Dr., 85614 Kirchseeon (DE); Rohm, Peter, 85276 Pfaffenhofen (DE); Tillmann, Berthold, 85452 Moosinning (DE)
(74) Vertreter: Repkow, Ines

(56) Entgegenhaltungen:
- EP-A- 0 235 559
- EP-A- 0 586 715
- DE-A- 19 732 842
- US-A- 4 641 276

## Beschreibung

Die vorliegende Erfindung betrifft eine Vorrichtung gemäß dem Oberbegriff des Patentanspruchs 1.

Wenn die Vorrichtung ein Mikrocontroller ist, werden durch die Steuerregister insbesondere die Peripherieeinheiten des Mikrocontrollers, genauer gesagt darin enthaltene Schalter, Multiplexer oder sonstige steuerbare Elemente gesteuert. Die Steuerregister sind üblicherweise Bestandteil der zu steuernden Peripherieeinheiten und werden über einen die Peripherie-einheiten und die CPU des Mikrocontrollers miteinander verbindenden Bus von der CPU beschrieben. Es existiert eine feste Zuordnung, welche Elemente der Peripherieeinheiten durch welche Steuerregisterelemente gesteuert werden, wobei die Steuerregisterelemente und die von diesen zu steuernden Elemente über elektrische Leitungen miteinander verbunden sind, so daß die zu steuernden Elemente direkt durch die im Steuerregister gespeicherten Daten gesteuert werden.

Die genannten Verbindungen zwischen den Steuerregisterelementen und den zu steuernden Elementen sowie die Verbindungen zwischen den Steuerregisterelementen und der diese beschreibenden Einrichtung können mitunter ein Problem darstellen.

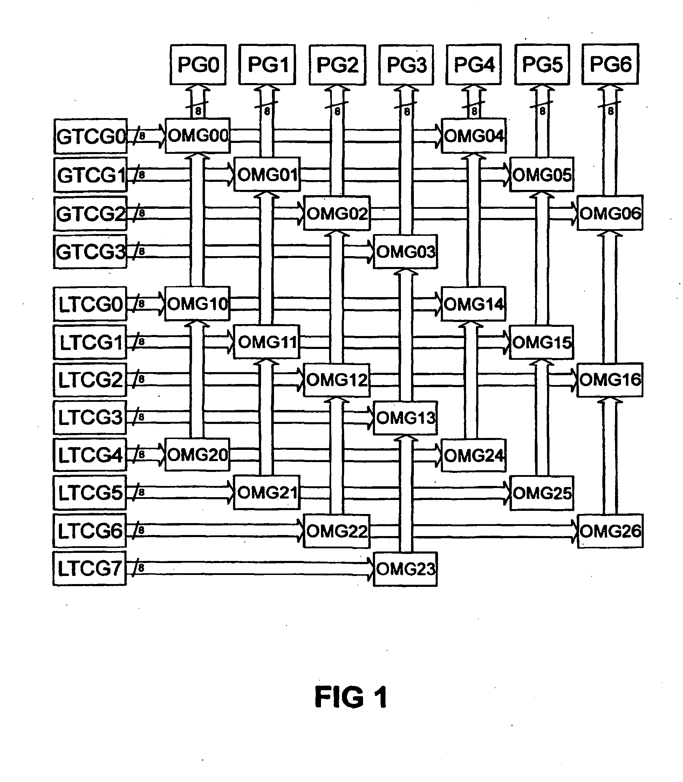

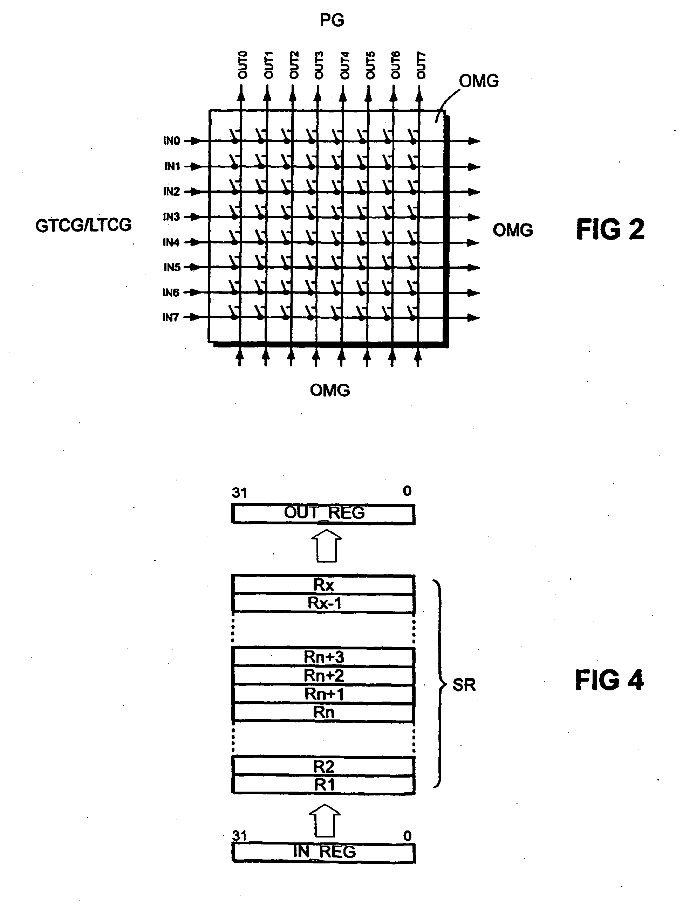

Ein Beispiel, bei welchem dies der Fall ist, ist in den Figuren 1 und 2 dargestellt.

Die Figur 1 zeigt einen sogenannten cross-bar-switch, über welchen aus in der Figur 1 mit GTCG0 bis GTCG3 und LTCG0 bis LTCG7 bezeichneten Datenquellen ausgegebene Daten zu in der Figur 1 mit PG0 bis PG6 bezeichneten Datensenken transferiert werden, wobei es über in der Figur 1 mit OMG00 bis OMG26 bezeichnete Schalter-Netzwerke (Multiplexer) einstellbar ist, welche Daten wohin transferiert werden.

Der Aufbau eines der Schalter-Netzwerke OMG00 bis OMG26 ist in Figur 2 veranschaulicht.

Wie aus der Figur 2 ersichtlich ist, weist das gezeigte Schalter-Netzwerk insgesamt 64 Schalter auf, wobei diese Schalter vorzugsweise durch Steuerregister, beispielsweise durch zwei 32-Bit-Steuerregister gesteuert werden.

In der in der Figur 1 gezeigten Anordnung sind 21 Schalter-Netzwerke nach Art der Figur 2 enthalten, so daß zur Steuerung dieser Schalter-Netzwerke insgesamt 42 32-Bit-Register erforderlich sind. Für den Anschluß dieser Steuerregister an die CPU und an die zu steuernden Elemente sind insgesamt mehrere tausend Verbindungsleitungen erforderlich, die eine beträchtliche Länge annehmen können. Damit nehmen der Verdrahtungsaufwand und die Chipfläche eine nicht mehr akzeptable Größe an, zumal die in der Figur 1 gezeigte Anordnung schon ohne die genannten Verbindungsleitungen von einem dichten Leitungsnetz überzogen ist. Als Abhilfe könnte vorgesehen werden, die einzelnen Schalter nicht unabhängig voneinander anzusteuern, sondern mehr oder weniger große Schalter-Gruppen gleich anzusteuern. Dadurch ließe sich der Verdrahtungsaufwand etwas verringern. Andererseits müßte dafür jedoch in Kauf genommen werden, daß die Anordnung gemäß Figur 1 nicht mehr so flexibel einsetzbar wäre, und darüber hinaus wäre mit einem zwar geringeren, aber immer noch großen Verdrahtungsaufwand zu rechnen.

Eine alle Merkmale des Oberbegriffs des Patentanspruchs 1 aufweisende Vorrichtung ist aus Dokument DE 37 27 723 A bekannt. Eine weitere Vorrichtung mit einem Schieberegister, welches allerdings keine Steuerfunktion aufweist, ist aus Dokument UA-A-5 212 651 bekannt. Den genannten Dokumenten sind jedoch keine Anregungen zur Lösung der vorstehend erwähnten Probleme entnehmbar.

Der vorliegenden Erfindung liegt daher die Aufgabe zugrunde, eine Möglichkeit zu finden, durch welche sich die Steuerung von zu steuernden Komponenten eines Mikrocontrollers, Mikroprozessors oder Signalprozessors unter Verwendung von Steuerregistern mit geringerem Aufwand realisieren läßt als es bisher der Fall ist.

Diese Aufgabe wird durch das in Patentanspruch 1 beanspruchte Steuerregister gelöst.

### Dadurch

- muß nicht mehr jedes der Steuerregisterelemente, sondern nur noch ein oder einige wenige Steuerregisterelemente (ein Steuerregisterelement pro Schieberegister) mit der das Steuerregister beschreibenden Einrichtung verbunden werden, und
- können die Steuerregisterelemente in unmittelbarer Nähe der durch sie zu steuernden Elemente angeordnet werden.

Dies hat den positiven Effekt, daß sich die Länge der Verbindungsleitungen zwischen den Steuerregisterelementen und der diese beschreibenden Einrichtung und die Länge der Verbindungsleitungen zwischen den Steuerregisterelementen und den durch sie zu steuernden Elementen erheblich verkürzen lassen.

Vorteilhafte Weiterbildungen der Erfindung sind den Unteransprüchen, der folgenden Beschreibung, und den Figuren entnehmbar.

Die Erfindung wird nachfolgend anhand von Ausführungsbeispielen unter Bezugnahme auf die Figuren näher erläutert. Es zeigen
- Figur 1: eine Anordnung, bei welcher sich der Einsatz des im folgenden beschriebenen Steuerregisters als vorteilhaft erweist,
- Figur 2: den Aufbau eines von in der Anordnung gemäß Figur 1 verwendeten Schalter-Netzwerken,
- Figur 3: ein erstes Ausführungsbeispiel des im folgenden beschriebenen Steuerregisters,
- Figur 4: den Aufbau des in der Figur 3 gezeigten Steuer-registers wie er sich aus der Sicht des Benutzers darstellt,
- Figur 5: ein zweites Ausführungsbeispiel des im folgenden beschriebenen Steuerregisters, und
- Figur 6: ein drittes Ausführungsbeispiel des im folgenden beschriebenen Steuerregisters.

Das im folgenden beschriebene Steuerregister ist Bestandteil eines Mikrocontrollers, genauer gesagt einer Peripherieeinheit desselben, beispielsweise eines in der Figur 1 gezeigten cross-bar-switch, einer I/O-Schnittstelle, eines A/D-Wandlers, eines DMA-Controllers, eines CAN-Controllers, eines Timers oder einer beliebigen anderen Peripherieeinheit.

Es sei jedoch bereits an dieser Stelle darauf hingewiesen, daß das Steuerregister auch in anderen programmgesteuerten Einheiten wie Mikroprozessoren, Signalprozessoren etc., und auch in beliebigen anderen elektrischen Schaltungen eingesetzt werden kann.

Das Steuerregister wird im betrachteten Beispiel durch die CPU des Mikrocontrollers beschrieben. Es könnte aber auch durch eine andere Peripherieeinheit oder eine außerhalb des Mikrocontrollers vorgesehene Einrichtung beschrieben werden.

Das vorliegend betrachtete Steuerregister zeichnet sich dadurch aus, daß es durch wenigstens ein Schieberegister gebildet wird, dessen Elemente einzeln oder gruppenweise mit gegenseitigem Abstand über die elektrische Schaltung verteilt sind.

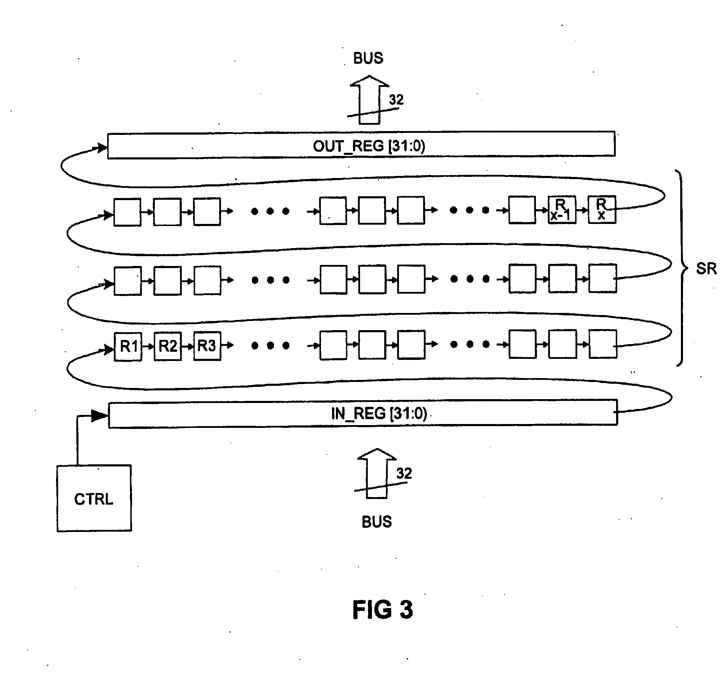

Ein erstes Ausführungsbeispiel eines solchen Steuerregisters ist in der Figur 3 veranschaulicht.

Die in der Figur 3 gezeigte Anordnung besteht aus einem Dateneingaberegister IN_REG, einem Datenausgaberegister OUT_REG, einem dazwischen angeordneten Steuerregister SR, und einer Steuereinrichtung CTRL,
- wobei das Dateneingaberegister IN_REG durch ein Schieberegister gebildet wird, dessen Elemente parallel beschreibbar sind, und welches gespeicherte Daten unter Durchführung einer Schiebeoperation sequentiell ausgibt,
- wobei das Datenausgaberegister OUT_REG durch ein Schieberegister gebildet wird, welches ihm zugeführte Daten sequentiell übernimmt und intern weiterschiebt, und dessen Elemente parallel auslesbar sind,
- wobei das Steuerregister SR durch ein Schieberegister gebildet wird, welches die aus dem Dateneingaberegister IN_REG hinausgeschobenen Daten in dem für alle Schieberegister gemeinsamen, von der Steuereinrichtung CTRL erzeugten Schiebetakt übernimmt und intern weiterschiebt, und einhergehend damit im Steuerregister SR gespeicherte Daten im gemeinsamen Schiebetakt zum Datenausgaberegister OUT_REG weiterschiebt,
- wobei die einzelnen Elemente R1 bis Rx des Steuerregisters SR anders als bei normalen Steuerregistern und auch anders als bei normalen Schieberegistern nicht unmittelbar benachbart zueinander, sondern mit mehr oder weniger großen gegenseitigen Abständen über die Peripherieeinheit, deren Bestandteil die in der Figur 3 gezeigte Anordnung ist, verteilt sind, und
- wobei die Steuerregisterelemente R1 bis Rx vorzugsweise jeweils in der Nähe der Elemente angeordnet sind, die durch die in den jeweiligen Steuerregisterelementen gespeicherten Daten gesteuert werden sollen.

Wie vorstehend bereits erwähnt wurde, wird das Steuerregister SR durch die CPU des Mikrocontrollers beschrieben. Das Beschreiben des Steuerregisters SR erfolgt jedoch auf dem Umweg über das Dateneingaberegister IN_REG. Genauer gesagt werden die von der CPU in das Steuerregister SR zu schreibenden Daten zunächst über einen Bus BUS in das Dateneingaberegister IN_REG geschrieben.

Der Bus BUS und das Dateneingaberegister IN_REG sind im betrachteten Beispiel jeweils 32 Bits breit, und die über den Bus BUS übertragenen Daten werden parallel in das Dateneingaberegister IN_REG geschrieben. Der Vollständigkeit halber sei darauf hingewiesen, daß die Breite des Dateneingaberegisters IN_REG und die Breite des Busses BUS unabhängig voneinander beliebig groß sein können.

Die in das Dateneingaberegister IN_REG eingeschriebenen Daten werden sodann im Takt eines durch die Steuereinrichtung CTRL erzeugten Schiebetaktes sequentiell aus dem Dateneingaberegister IN_REG hinausgeschoben und dem Steuerregister SR zugeführt.

Das Steuerregister SR übernimmt die ihm zugeführten Daten und schiebt sie intern von Steuerregisterelement zu Steuerregisterelement weiter. Der Takt, mit welchem dies geschieht, ist der von der Steuereinrichtung CTRL erzeugte und auch vom Dateneingaberegister IN_REG verwendete Schiebetakt.

Der Schiebevorgang wird so lange durchgeführt, bis die Daten zu den Steuerregisterelementen, für welche sie bestimmt sind, weitergeschoben sind. Die Steuereinrichtung CTRL sorgt dafür, daß dies gewährleistet ist.

Die Steuerregisterelemente R1 bis Rx sind über in der Figur 1 nicht gezeigte Leitungen mit den durch sie zu steuernden Elementen, genauer gesagt mit den durch sie zu steuernden Schaltern, Multiplexern etc. verbunden. Die Steuerregisterelemente steuern damit die durch sie zu steuernden Elemente wie es bei einem herkömmlichen Steuerregister der Fall ist.

Beim Schieben der im Dateneingaberegister IN_REG gespeicherten Daten in das Steuerregister SR werden die im Steuerregister SR gespeicherten Daten sequentiell aus diesem hinausgeschoben und dem Datenausgaberegister OUT_REG zugeführt. Das Datenausgaberegister OUT_REG übernimmt die ihm zugeführten Daten und schiebt sie intern von Datenausgaberegisterelement zu Datenausgaberegisterelement weiter. Der Takt, mit welchem dies geschieht, ist der von der Steuereinrichtung CTRL erzeugte und auch vom Dateneingaberegister IN_REG und vom Steuerregister SR verwendete Schiebetakt.

Die im Datenausgaberegister OUT_REG gespeicherten Daten können von der CPU über den Bus BUS parallel ausgelesen werden.

Das Datenausgaberegister OUT_REG ist für die Steuerung der durch das Steuerregister SR zu steuernden Elemente nicht erforderlich und könnte auch weggelassen werden. Das Vorsehen des Datenausgaberegisters OUT_REG, dessen Beschreiben durch das Steuerregister SR und dessen Auslesen durch die CPU erweisen sich jedoch beim Testen der Anordnung als großer Vorteil: durch einen Vergleich der in das Dateneingaberegister IN_REG eingeschriebenen Daten mit den nach einer bestimmten Anzahl von Schiebetakten aus dem Datenausgaberegister OUT_REG ausgelesenen Daten läßt sich erkennen, ob alle Steuerregisterelemente ordnungsgemäß arbeiten.

Die Anzahl der Elemente R1 bis Rx des Steuerregisters SR kann beliebig groß sein. Sie kann insbesondere auch kleiner oder größer sein als die Anzahl der Elemente des Dateneingaberegisters IN_REG und/oder die Anzahl der Elemente des Datenausgaberegisters OUT_REG und/oder die Breite des Busses BUS.

Wie vorstehend bereits erläutert wurde, steuert das beschriebene Steuerregister die von ihm zu steuernden Elemente wie ein herkömmliches Steuerregister.

Bedingt durch den Umstand, daß das Steuerregister durch ein Schieberegister gebildet wird, dessen Elemente mit gegenseitigem Abstand über die elektrische Schaltung verteilt sind, läßt sich die Länge der Verbindungsleitungen von und zu den Steuerregisterelementen erheblich verringern.

Dies hat zwei Gründe. Der erste Grund besteht darin, daß nicht jedes Steuerregisterelement über eine eigene Verbindungsleitung mit der das Steuerregister beschreibenden Einrichtung verbunden sein muß. Es genügt, wenn eines der Steuerregisterelemente mit der das Steuerregister beschreibenden Einrichtung verbunden ist, und die restlichen Steuerregisterelemente unter Bildung einer Steuerregisterelemente-Kette untereinander verbunden sind. Der zweite Grund für die Verkürzung der Länge der Verbindungsleitungen besteht darin, daß die Steuerregisterelemente unabhängig voneinander an beliebigen Stellen innerhalb der diese enthaltenden Peripherieeinheit angeordnet werden können, so daß sie jeweils in unmittelbarer Nähe zu den von ihnen jeweils zu steuernden Elementen angeordnet werden können und folglich jeweils nur sehr kurze Verbindungsleitungen zur Verbindung der Steuerregisterelemente mit den von diesen zu steuernden Elementen erforderlich sind.

Für den Benutzer stellt sich der Steuerregister der in der Figur 3 gezeigten Anordnung wie ein in Figur 4 gezeigtes FIFO dar.

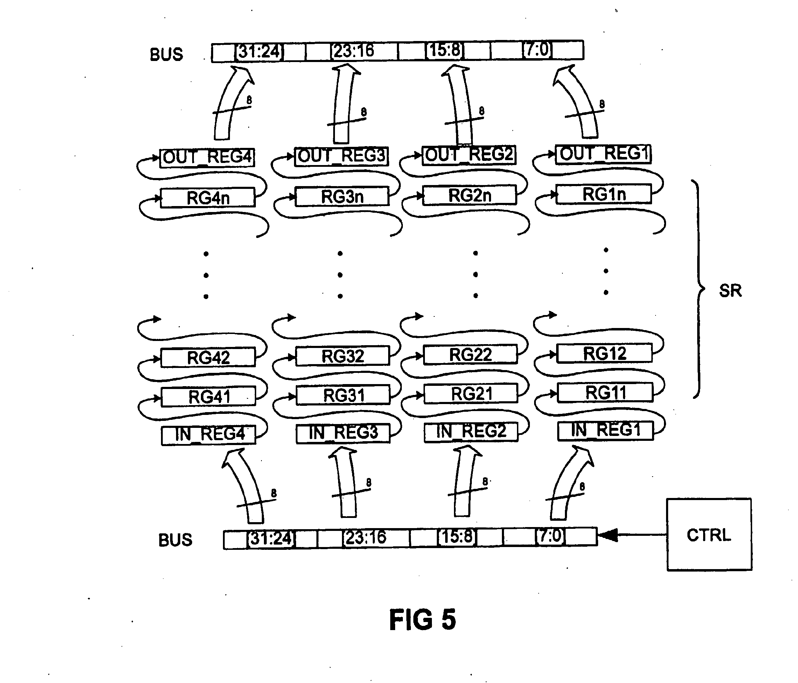

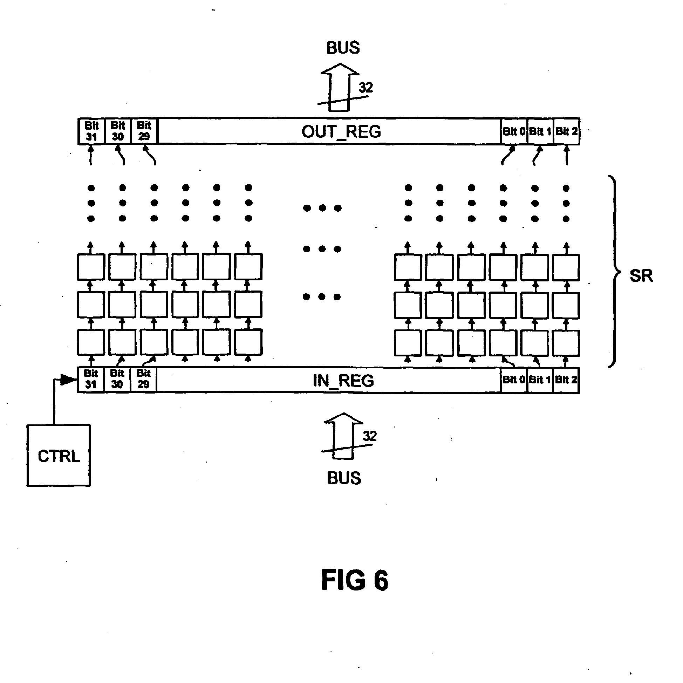

Die in der Figur 3 gezeigte Anordnung läßt sich auf verschiedene Art und Weise modifizieren. Zwei Beispiele hierfür sind in den Figuren 5 und 6 gezeigt.

Bei der in der Figur 5 gezeigten Anordnung
- sind anstelle eines einzigen Dateneingaberegisters IN_REG vier Dateneingaberegister IN_REG1 bis IN_REG4 vorgesehen,
- sind anstelle eines einzigen Datenausgaberegisters OUT_REG vier Datenausgaberegister OUT_REG1 bis OUT_REG4 vorgesehen,
- besteht das Steuerregister SR aus vier nicht miteinander in Verbindung stehenden, also prinzipiell unabhängig voneinander betreibbaren Schieberegistern S1 bis S4, wobei diese Schieberegister jeweils zwischen einem der Dateneingaberegister IN_REG1 bis IN_REG4 und einem dem betreffenden Dateneingaberegister zugeordneten Datenausgaberegister angeordnet sind, und
- sind die Steuerregisterelemente jeweils in mehrere (im betrachteten Beispiel jeweils 8) Steuerregisterelemente umfassende Steuerregisterelemente-Gruppen RG11 bis RG4n unterteilt, wobei die Steuerregisterelemente-Gruppen jeweils eine zusammenhängende Einheit bilden, und wobei aber die einzelnen Steuerregisterelemente-Gruppen mit gegenseitigem Abstand unabhängig voneinander über die die Anordnung gemäß Figur 5 enthaltende Peripherieeinheit verteilt sind.

Von den mehreren Dateneingaberegistern IN_REG1 bis IN_REG4 enthält jedes nur einen bestimmten Bruchteil (im betrachteten Beispiel jeweils ein Viertel) der Elemente des einzigen Dateneingaberegisters IN_REG gemäß Figur 3, wobei jedoch die Summe der Elemente aller Dateneingaberegister IN_REG1 bis IN_REG4 der Anzahl der Registerelemente des einzigen Dateneingaberegisters IN_REG gemäß Figur 3 entspricht. Die verschiedenen Dateneingaberegister IN_REG1 bis IN_REG4 sind jeweils unabhängig voneinander betreibbare Schieberegister.

Entsprechendes gilt für die Datenausgaberegister OUT_REG1 bis OUT_REG4.

Das Beschreiben des Steuerregisters SR erfolgt über die Dateneingaberegister IN_REG1 bis IN_REG4. Genauer gesagt werden die von der CPU in das Steuerregister SR zu schreibenden Daten zunächst über den Bus BUS in die Dateneingaberegister IN_REG1 bis IN_REG4 geschrieben.

Der Bus BUS ist hier wiederum 32 Bits breit, und die Dateneingaberegister IN_REG1 bis IN_REG4 sind jeweils 8 Bits breit. Die Dateneingaberegister IN_REG1 bis IN_REG4 werden gleichzeitig parallel beschrieben. Der Vollständigkeit halber sei darauf hingewiesen, daß die Dateneingaberegister IN_REG1 bis IN_REG4 und der Bus BUS auch beliebige andere Größen aufweisen können. Dabei ist es nicht erforderlich, daß alle Dateneingaberegister gleich groß sind.

Die in das Dateneingaberegister IN_REG1 eingeschriebenen Daten werden sodann im Takt eines durch die Steuereinrichtung CTRL erzeugten Schiebetaktes sequentiell aus dem Dateneingaberegister IN_REG1 hinausgeschoben und dem sich zwischen dem Dateneingaberegister IN_REG1 und dem Datenausgaberegister OUT_REG1 erstreckenden ersten Schieberegister S1 des Steuerregisters SR zugeführt.

Das erste Schieberegister S1 übernimmt die ihm zugeführten Daten und schiebt sie intern von Steuerregisterelement zu Steuerregisterelement weiter. Der Takt, mit welchem dies geschieht, ist der von der Steuereinrichtung CTRL erzeugte und auch vom Dateneingaberegister IN_REG1 verwendete Schiebetakt.

Der Schiebevorgang wird so lange durchgeführt, bis die Daten zu den Steuerregisterelementen, für welche sie bestimmt sind, weitergeschoben sind. Die Steuereinrichtung CTRL sorgt dafür, daß dies der Fall ist. In diesem Zusammenhang sei angemerkt, daß die mehreren Schieberegister S1 bis S4 des Steuer-registers unabhängig voneinander beliebig viele Steuerregisterelemente aufweisen können

Beim Schieben der im Dateneingaberegister IN_REG1 gespeicherten Daten in das erste Schieberegister S1 werden die im ersten Schieberegister gespeicherten Daten sequentiell aus diesem hinausgeschoben und dem Datenausgaberegister OUT_REG1 zugeführt. Das Datenausgaberegister OUT_REG1 übernimmt die ihm zugeführten Daten und schiebt sie intern von Datenausgaberegisterelement zu Datenausgaberegisterelement weiter. Der Takt, mit welchem dies geschieht, ist der von der Steuereinrichtung CTRL erzeugte und auch vom Dateneingaberegister IN_REG1 und vom der ersten Schieberegister verwendete Schiebetakt.

Exakt die selben Vorgänge laufen beim Beschreiben
- des zwischen dem zweiten Dateneingaberegister IN_REG2 und dem diesem zugeordneten zweiten Datenausgaberegister OURT_REG2 vorgesehenen zweiten Schieberegisters S2,
- des zwischen dem dritten Dateneingaberegister IN_REG3 und dem diesem zugeordneten dritten Datenausgaberegister OURT_REG3 vorgesehenen dritten Schieberegisters S3, und
- des zwischen dem vierten Dateneingaberegister IN_REG4 und dem diesem zugeordneten vierten Datenausgaberegister OURT_REG4 vorgesehenen vierten Schieberegisters S4
ab, wobei jeweils eine, mehrere oder alle Schieberegister gleichzeitig beschrieben werden können.

Die in den Datenausgaberegistern OUT_REG1 bis OUT_REG4 gespeicherten Daten können von der CPU über den Bus BUS gleichzeitig parallel ausgelesen werden und zum Testen des Steuerregisters verwendet werden.

Die vorhandenen Unterschiede im Aufbau zwischen der in der Figur 5 gezeigten Anordnung und der in der Figur 3 gezeigten Anordnung wirken sich hauptsächlich auf das vorstehend beschriebene Beschreiben des Steuerregisters aus. Die eigentliche Funktion des Steuerregisters wird dadurch nicht beeinflußt. D.h., die Steuerung der zu steuernden Elemente durch das Steuerregister erfolgt wie bei der in der Figur 3 gezeigten und unter Bezugnahme darauf beschriebenen Anordnung.

Die in der Figur 5 gezeigte Anordnung weist auch die Vorteile der in der Figur 3 gezeigten Anordnung auf. D.h., sie läßt sich mit einem relativ geringen Verdrahtungsaufwand praktisch realisieren.

Die in der Figur 5 gezeigte Anordnung weist gegenüber der in der Figur 3 gezeigten Anordnung zwei Vorteile auf: es ist möglich, pro Zeiteinheit eine größere Anzahl von Steuerregisterelementen zu beschreiben, und es ist möglich, nur bestimmte Teile der Steuerregisterelemente (nur eine einzelne oder bestimmte mehrere Schieberegister des Steuerregisters) zu beschreiben.

Es dürfte einleuchten, daß das Steuerregister auch mehr oder weniger als vier Schieberegister enthalten kann. Ein Beispiel, bei welchem das Steuerregister 32 Schieberegister enthält, ist in Figur 6 gezeigt.

Die in der Figur 6 gezeigte Anordnung ist zusammen mit den zur Figur 5 gegebenen Erläuterungen ohne eine ins Detail gehende Beschreibung verständlich.

### Abschließend sei darauf hingewiesen,

- die Anzahl der Steuerregisterelemente, die die Steuerregisterelemente-Gruppen der Anordnung gemäß Figur 5 umfassen, unabhängig von der Anzahl und Größe der Dateneingaberegister und Datenausgaberegister sind,
- das Steuerregister beliebig viele Steuerregisterelemente-Gruppen aufweisen kann, wobei jede Steuerregisterelemente-Gruppe unabhängig von der Größe aller anderen Steuerregisterelemente-Gruppen beliebig groß sein kann,
- daß auch in den Anordnungen gemäß Figur 3 und Figur 6 mehrere Steuerregisterelemente umfassende Steuerregisterelemente-Gruppen vorgesehen werden können.

Das beschriebene Steuerregister ermöglicht es unabhängig von den Einzelheiten der praktischen Realisierung, die Länge der Verbindungsleitungen zwischen dem Steuerregister und der diese beschreibenden Einrichtung und zwischen dem Steuerregister und den durch diese zu steuernden Elementen gering zu halten.

### Bezugszeichenliste

- BUS: Bus
- CTRL: Steuereinrichtung
- GTCGx: Datenquelle
- IN_REG: Dateneingaberegister
- LTCGx: Datenquelle
- OMGx: Schalter-Netzwerk
- OUT_REG: Datenausgaberegister
- PGx: Datensenke
- Rx: Steuerregisterelement
- RGx: Steuerregisterelemente-Gruppe
- SR: Steuerregister
- Sx: Schieberegister

## Patentansprüche

1. Mikrocontroller, Mikroprozessor oder Signalprozessor, welcher ein Steuerregister zur Steuerung von zu steuernden Komponenten dieses Mikrocontrollers, Mikroprozessors oder Signalprozessors enthält, wobei das Steuerregister (SR) durch wenigstens ein Schieberegister gebildet wird,
**dadurch gekennzeichnet,**
**daß** Elemente (Rx, RGx) des Schieberegisters und somit Steuerregisters (SR) einzeln oder gruppenweise mit gegenseitigem Abstand über den Mikrocontroller, Mikroprozessor oder Signalprozessor verteilt sind, und
**daß** die Steuerregisterelemente (Rx) oder Steuerregisterelemente-Gruppen (RGx) jeweils in der Nähe der durch diese zu steuernden Komponenten des Mikrocontrollers, Mikroprozessors oder Signalprozessors angeordnet sind.

2. Mikrocontroller, Mikroprozessor oder Signalprozessor nach Anspruch 1,
**dadurch gekennzeichnet,**
**daß** das Beschreiben des Steuerregisters (SR) so erfolgt, daß in das Steuerregister zu schreibende Daten
- parallel in ein durch ein Schieberegister gebildetes Dateneingaberegister (IN_REG) geschrieben werden,
- von diesem sequentiell dem Steuerregister zugeführt werden, und
- vom Steuerregister im Schiebetakt des Dateneingaberegisters übernommen und intern weitergeschoben werden.

3. Mikrocontroller, Mikroprozessor oder Signalprozessor nach Anspruch 2,
**dadurch gekennzeichnet,**
**daß** jedem Schieberegister (S1 bis S4) des Steuerregisters (SR) ein eigenes Dateneingaberegister (IN_REG) zugeordnet ist.

4. Mikrocontroller, Mikroprozessor oder Signalprozessor nach einem der vorhergehenden Ansprüche,
**dadurch gekennzeichnet,**
**daß** beim Beschreiben des Steuerregisters (SR) in diesem gespeicherte Daten aus diesem hinausgeschoben und einem durch ein Schieberegister gebildetes Datenausgaberegister (OUT REG) zugeführt werden, welches die ihm zugeführten Daten im Schiebetakt des Steuerregisters übernimmt und intern weiterschiebt, und dessen Inhalt parallel auslesbar ist.

5. Mikrocontroller, Mikroprozessor oder Signalprozessor nach einem der vorhergehenden Ansprüche
**dadurch gekennzeichnet,**
**daß** jedem Schieberegister (S1 bis S4) des Steuerregisters (SR) ein eigenes Datenausgaberegister (OUT-REG) zugeordnet ist

6. Mikrocontroller, Mikroprozessor oder Signalprozessor nach einem der vorhergehenden Ansprüche,
**dadurch gekennzeichnet,**
**daß** das Steuerregister mehrere Schieberegister (S1 bis S4) enthält, und die mehreren Schieberegister (S1 bis S4) des Steuerregisters (SR) unabhängig voneinander betreibbare Schieberegister sind.

## Claims

1. Microcontroller, microprocessor or signal processor, which comprises a control register for controlling components of this microcontroller, microprocessor or signal processor to be controlled, wherein the control register (SR) is formed by at least one shift register, **characterized in that** elements (Rx, RGx) of the shift register and hence of the control register (SR) are distributed over the microcontroller, microprocessor or signal processor at mutual intervals, individually or in groups and **in that** the control register elements (Rx) or control register element groups (RGx) are in each case arranged in the vicinity of the components of the microcontroller, microprocessor or signal processor to be controlled thereby.

2. Microcontroller, microprocessor or signal processor according to Claim 1, **characterized in that** the control register (SR) is written in such a way that data to be written to the control register
- is written in parallel into a data input register (IN_REG) formed by a shift register,
- is supplied by the latter sequentially to the control register, and
- is accepted by the control register at the shift cycle rate of the data input register and are shifted onward internally.

3. Microcontroller, microprocessor or signal processor according to Claim 2, **characterized in that** each shift register (S1 to S4) of the control register (SR) is assigned its own data input register (IN_REG).

4. Microcontroller, microprocessor or signal processor according to one of the preceding claims, **characterized in that** as the control register (SR) is written, data stored in the latter is shifted out of the latter and supplied to a data input register (OUT_REG) which is formed by a shift register, which accepts the data supplied to it at the shift cycle rate of the control register and shifts said data onward internally, and whose content can be read out in parallel.

5. Microcontroller, microprocessor or signal processor according to one of the preceding claims, **characterized in that** each shift register (S1 to S4) of the control register (SR) is assigned its own data output register (OUT_REG).

6. Microcontroller, microprocessor or signal processor according to one of the preceding claims, **characterized in that** the control register comprises a plurality of shift registers (S1 to S4) and the plurality of shift registers (S1 to S4) of the control register (SR) are shift registers that can be operated independently of one another.

## Revendications

1. Microcontrôleur, microprocesseur ou processeur de signaux, qui comprend un registre de contrôle pour contrôler des composants à contrôler de ce microcontrôleur, microprocesseur ou processeur de signaux, le registre de contrôle (SR) étant formé par au moins un registre à décalage,
**caractérisé en ce que**
des éléments (Rx, RGx) du registre à décalage, et par conséquent du registre de contrôle (SR) sont répartis séparément ou en groupes à intervalle mutuel sur le microcontrôleur, le microprocesseur ou le processeur de signaux, et
**en ce que** les éléments (Rx) du registre de contrôle ou les groupes d'éléments (RGx) du registre de contrôle sont disposés à chaque fois à proximité des composants du microcontrôleur, du microprocesseur ou du processeur de signaux qu'ils doivent contrôler.

2. Microcontrôleur, microprocesseur ou processeur de signaux selon la revendication 1,
**caractérisé en ce que**
la description du registre de contrôle (SR) s'effectue de telle sorte que les données à écrire dans le registre de contrôle
- soient écrites en parallèle dans un registre d'entrée de données (IN_REG) formé par un registre à décalage,
- soient acheminées par celui-ci de manière séquentielle au registre de contrôle, et
- soient reprises par le registre de contrôle pendant la période d'horloge du registre d'entrée de données et soient transférées en interne.

3. Microcontrôleur, microprocesseur ou processeur de signaux selon la revendication 2,
**caractérisé en ce que**
l'on associe à chaque registre à décalage (S1 à S4) du registre de contrôle (SR), un registre d'entrée de données propre (IN_REG).

4. Microcontrôleur, microprocesseur ou processeur de signaux selon l'une quelconque des revendications précédentes,
**caractérisé en ce que**
lors de la description du registre de contrôle (SR), les données mémorisées dans celui-ci sont sorties de celui-ci et sont acheminées à un registre de sortie de données (OUT_REG) formé par un registre à décalage, qui reprend les données qui lui sont acheminées pendant la période d'horloge du registre de contrôle et les transfère en interne, et dont le contenu peut être lu en parallèle.

5. Microcontrôleur, microprocesseur ou processeur de signaux selon l'une quelconque des revendications précédentes,
**caractérisé en ce que**
l'on associe à chaque registre à décalage (S1 à S4) du registre de contrôle (SR) un registre de sortie de données propre (OUT_REG).

6. Microcontrôleur, microprocesseur ou processeur de signaux selon l'une quelconque des revendications précédentes,
**caractérisé en ce que**
le registre de contrôle comprend plusieurs registres à décalage (S1 à S4) et les plusieurs registres à décalage (S1 à S4) du registre de contrôle (SR) sont des registres à décalage pouvant fonctionner indépendamment les uns des autres.
